# EUROPÄISCHE PATENTSCHRIFT

(11) **EP 1 099 066 B1**
(45) Veröffentlichungstag und Bekanntmachung des Hinweises auf die Patenterteilung: **20.02.2002**
(21) Anmeldenummer: 99945857.3
(22) Anmeldetag: 01.07.1999
(51) Int. Cl.: F16H 61/00, G01L 19/00

(54) **STEUERGERÄT IN EINEM KRAFTFAHRZEUG UND VERFAHREN ZUM BEFESTIGEN EINES VON DIESEM VERWENDETEN DRUCKSENSORS**
CONTROL DEVICE IN A MOTOR VEHICLE AND METHOD TO MOUNT A PRESSURE GAUGE WHICH IS USED BY THE CONTROL DEVICE
APPAREIL DE COMMANDE MONTE DANS UN VEHICULE ET METHODE A INSTALLER UN CAPTEUR DE PRESSION UTILISE PAR LEDIT APPAREIL

(30) Priorität: 29.07.1998 DE 19834212
(43) Veröffentlichungstag der Anmeldung: 16.05.2001
(73) Patentinhaber: SIEMENS AKTIENGESELLSCHAFT, 80333 München (DE)
(72) Erfinder: ALBERT, Roland, D-93047 Regensburg (DE); FRITZSCHE, Christian, D-93047 Regensburg (DE)
(86) Internationale Anmeldenummer: DE9902001
(87) Internationale Veröffentlichungsnummer: WO0006926

(56) Entgegenhaltungen:
- EP-A- 0 238 846
- EP-A- 0 579 308
- DE-A- 19 737 821
- DE-U- 29 714 229
- US-A- 4 898 035
- US-A- 5 025 683

## Beschreibung

Die Erfindung betrifft ein Steuergerät nach dem Oberbegriff von Anspruch 1 und ein Verfahren nach Anspruch 7.

Automatische Getriebe für Personenkraftwagen werden überwiegend elektronisch gesteuert, wobei die elektronische Steuerung unter anderem die Signale von mehreren Sensoren im Kraftfahrzeug empfängt und auswertet. So muß mit einem oder mehreren Sensoren der Druck in dem Hydrauliköl des Getriebes gemessen werden, und zwar sowohl bei automatischen Stufengetrieben als auch bei stufenlosen oder CVT-Getrieben. Andererseits werten moderne Motorsteuerungen den Ansaugunterdruck aus und benötigen dazu einen in dem Ansaugtrakt untergebrachten Drucksensor.

Herkömmlicherweise ist die elektronische Getriebesteuerung in einem sie vor Umwelteinflüssen schützenden Gehäuse, auch als Elektronikbox bezeichnet, untergebracht. Der Hydraulikdruck wird mit einem oder mehreren eigenständigen Sensoren gemessen, die elektrisch mit der Steuerelektronik verbunden sind. Zum Schutz vor dem Umgebungsmedium (ATF-Getriebeöl) ist es notwendig, auch die Auswerte- und Steuerschaltung dicht zu verpacken. Es sind also zwei getrennte Gehäuse notwendig, die durch elektrische Leitungen miteinander verbunden sind, und diese Leitungen müßten drucköldicht durch die Gehäusewand hindurch geführt werden.

Fortschrittliche Getriebesteuerungen werden zunehmend in das Getriebegehäuse integriert (DE 295 13 950 U1). Die elektronische Steuerschaltung eines solchen Steuergeräts ist mit mindestens einem Sensor zum Messen den Hydraulikdrucks in dem Getriebe (im folgenden als Drucksensor bezeichnet) elektrisch verbunden, wobei der Drucksensor und die elektronische Steuerschaltung in einem gemeinsamen Gehäuse untergebracht sind und der Drucksensor durch eine Bohrung mit einer Hydraulikeinheit des Getriebes verbunden ist.

Eine bekannte Getriebesteuerung für ein Kraftfahrzeug weist eine in einem Getriebegehäuse angeordnete Bodenplatte aus Metall mit einer Bohrung auf, in der ein einteiliges Sensorgehäuse 71 mit einem angeformten Zapfen eingesteckt befestigt ist (De 297 14 229 U1, die ein Steuergerät nach dem Oberbegriff des Anspruchs 1 und ein Verfahren nach dem Oberbegriff des Anspruchs 7 offenbart.). Eine druckfeste Verbindung des Gehäuses mit der Bodenplatte erfolgt durch Kleben, Löten oder Schweißen oder dergleichen. Eine Abdichtung wird aber damit nicht erreicht, sondern mit einem O-Ring, der in einer endseitigen, hinterschnittenen Nut am Ende des Gehäusezapfens eingesprengt gehalten ist.

Eine Luftfilterinstandhaltungsanzeigevorrichtung weist einen Schalteraufbau auf, der eine Membran enthält, mit der der Druckabfall in einem Kraftfahrzeugluftfilter überwacht und dadurch eine zu starke Verschmutzung des Luftfilters erkannt wird (DE 196 30 985 A1). Der Schalteraufbau ist über eine Tülle an dem Luftfilter befestigt. Zum Abdichten der in einem Getriebegehäuse auftretenden Hydraulikdrücke ist eine solche Befestigung nicht geeignet.

Bekannt ist auch die automatische Befestigung eines Lagerzapfens oder Bolzens auf einem plattenförmigen Werkstück (FR 2 026 0401A). Der Bolzen hat eine flache Stirnfläche und eine senkrecht dazu angeordnete Ringfläche, die zusammen eine Schneide bilden. Mit dieser Schneide wird aus dem Werkstück eine kreisförmige Öffnung ausgestanzt, in der der Bolzen mit der Ringfläche und einer zweiten Ringfläche, die von der ersten durch eine Ringnut getrennt ist, eingedrückt und damit befestigt wird. Oder aber der Bolzen wird mit den genannten Ringflächen in eine vorhandene Bohrung eingedrückt. Dies alles dient nur zur Befestigung des Bolzens. Kanäle, die eine Hydraulikflüssigkeit führen, ein darin zu übertragender hoher Hydraulikdruck und die dabei zu beherrschenden Abdichtungsproblem sind in der Druckschrift nicht angesprochen.

Der Erfindung liegt die Aufgabe zugrunde, den Drucksensor auf kostengünstige Weise gegenüber dem zu messendem Mediumsdruck, insbesondere dem in der Getriebehydraulik herrschenden Hochdruck, abzudichten. Außerdem ist er gegenüber dem die elektronische Steuerschaltung enthaltenden Raum, d. h. gegenüber dem Umgebungsdruck, abzudichten.

Diese Aufgabe wird erfindungsgemäß durch das Steuergerät nach Anspruch 1 und das Verfahren nach Anspruch 7 gelöst.

Zweckmäßige Weiterbildungen der Erfindung sind in den Unteransprüchen niedergelegt.

Die Vorteile der Erfindung liegen unter anderem darin, daß die Probleme, die beim Einbau mehrerer Drucksensoren mit radialer Hochdruckdichtung durch geometrische Überbestimmung auftreten und die daraus resultierende Undichtigkeit vermieden werden.

Ein Ausführungsbeispiel der Erfindung wird im folgenden anhand der Zeichnung erläutert. Es zeigen:
- Figur 1:: ein automatisches Kraftfahrzeuggetriebe mit einem in das Getriebegehäuse integrierten erfindungsgemäßen Steuergerät in schematischer Darstellung;
- Figur 2:: ein Steuergerät gemäß der Erfindung und
- Figur 3:: Einzelheiten des Steuergeräts nach Figur 2 in vergrößerter Darstellung.

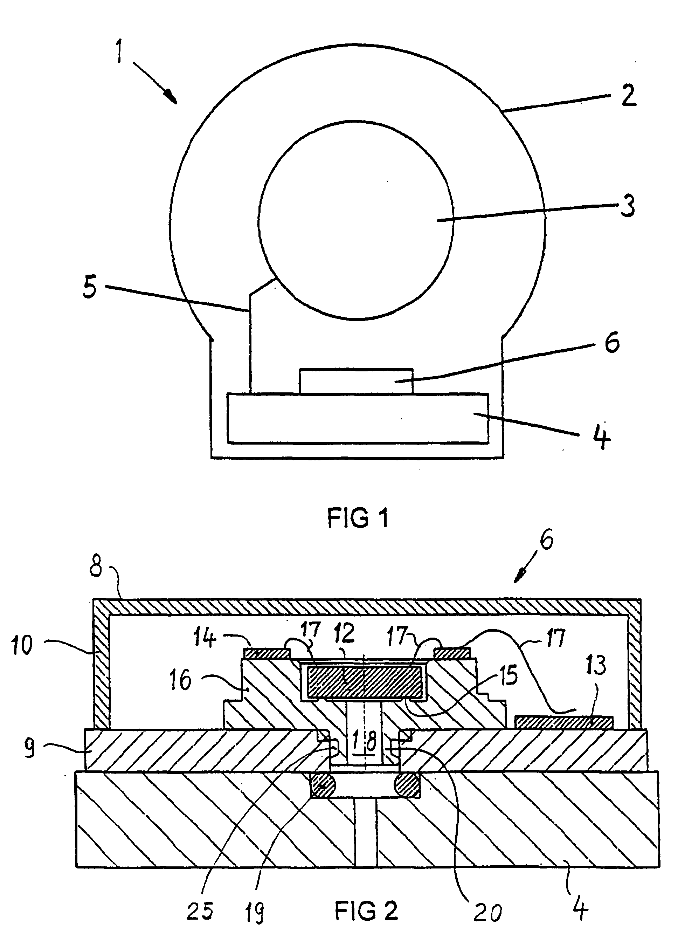

Ein automatisches Getriebe 1 weist ein die nachfolgend erwähnten Bestandteile einschließendes Getriebegehäuse 2 auf (Figur 1). Eine Übersetzungseinheit 3 betätigt durch hydraulischen Druck verschiedene Kupplungen, Bremsen und dergleichen in dem Getriebe und bestimmt damit die Getriebeübersetzung (bei einem CVT-Getriebe) oder rückt den erforderlichen Getriebegang (bei einem Stufengetriebe) ein.

Der erforderliche Hydraulikdruck wird von einer Hydraulikeinheit 4 über Hydraulikleitungen an die Übersetzungseinheit 3 geliefert. Auf der Hydraulikeinheit 4 ist ein Steuergerät 6 für das automatische Getriebe montiert.

Das Steuergerät 6 weist ein Gehäuse 8 auf, das aus einer metallischen Boden- oder Grundplatte 9 und einem kastenförmigen Deckel 10 besteht (Figur 2). Die Grundplatte 9 kann aber auch auf andere Weise druck- und flüssigkeitsdicht, d.h. insbesondere gegen unter Druck stehendem Getriebeöl dicht (im folgenden: drucköldicht), abgedeckt sein. Im Inneren des Gehäuses sind ein Drucksensor zum Messen von Hydraulikdrücken, im folgenden als Drucksensor 12 bezeichnet, und eine Steuerschaltung 13, die zum Beispiel auf einer Leiterplatte angeordnet ist, untergebracht.

Der Drucksensor 12 kann unterschiedlicher Bauart sein, vorteilhafterweise ist er zum Beispiel als ein an sich bekannter piezoresistiver Drucksensor ausgebildet. Eine Abgleichs- oder Auswerteschaltung 14, die zum Beispiel als Hybridschaltung ausgebildet ist, kann ebenfalls in dem Gehäuse 8 untergebracht sein. Sie dient der Signalverstärkung und/ oder - auswertung und sie weist abgleichbare Widerstände, zum Beispiel in Form von Leiterbahnen, auf, mit denen die Auswerteschaltung widerstandsmäßig an den Drucksensor 12 angeglichen wird.

Der Drucksensor 12 ist durch ein geeignetes Verbindungsmittel, zum Beispiel durch eine Schweißverbindung 15, auf einem metallischen Träger 16 drucköldicht befestigt und durch Bonddrähte 17 mit der Steuerschaltung 13 und gegebenenfalls mit der Hybridschaltung 14 verbunden.

Der zu messende Druck, das heißt der Druck des Hydrauliköls in dem Getriebe 1, gelangt über einen Druckkanal in Form einer Bohrung 18, die den Träger 16, die Grundplatte 9 und die Wand de Hydraulikeinheit 4 durchdringt, an die Unterseite des Drucksensors 12. Die Fuge zwischen der Oberfläche der Hydraulikeinheit 4 und der Unterseite der Grundplatte 9 ist mit einem axial zusammendrückbaren O-Ring 19 abgedichtet.

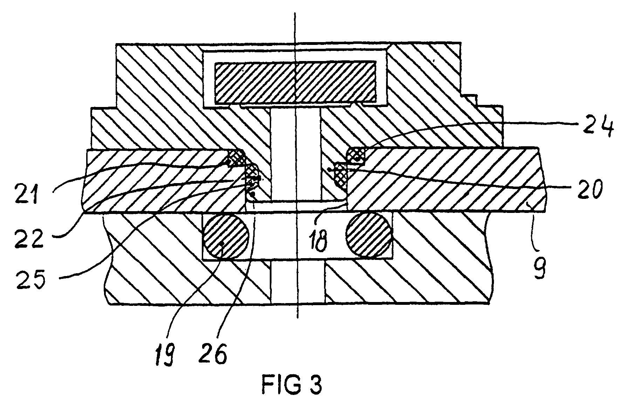

Der Träger 16 für den Drucksensor 12 ist mit einem - in der Zeichnung nach unten herausragenden - zweistufigen zylinderartigen Vorsprung 20 versehen (siehe auch Figur 3), dessen erste Stufe 21 einen größeren Durchmesser als die Bohrung 18 der Grundplatte 9 und dessen zweite Stufe 22 einen der Bohrung 18 entsprechenden Durchmesser aufweist.

Der Träger 16 ist aus einem härteren Metall, zum Beispiel aus Stahl, hergestellt als die Grundplatte 9, die zum Beispiel aus Aluminium besteht. Eine sichere Befestigung des Drucksensor-Trägers 16 auf der Grundplatte 9 wird dadurch erreicht, daß eine druckdichte und kraftschlüssige Verbindung zwischen dem Träger und der Grundplatte durch Materialverdrängung herbeigeführt wird, indem der Vorsprung 20 in die Bohrung 18 der Grundplatte eingedrückt wird, und zwar derart, daß ein von seiner ersten Stufe 21 verdrängter Teil des Werkstoffs der Grundplatte 9 hinter einen Absatz eindringt, der durch den Übergang zwischen den beiden Stufen 21, 22 des Vorsprungs 20 gebildet wird. Der Werkstoff der Grundplatte fließt dabei aus einem ringförmigen Bereich 24 der Grundplatte 9 in eine Ringnut 25 am Außenumfang der zweiten Stufe 22 des Vorsprungs 20.

In Figur 3 sind der ringförmige Bereich 24 und die Ringnut 25 doppelt schraffiert dargestellt, während in Figur 2 die Ringnut 25 zur besseren Erkennbarkeit unschraffiert dargestellt ist. Die Ringnut 25 wird durch die erste Stufe 21, die Außenfläche der zweiten Stufe 22 und durch einen Rand 26 des Vorsprungs 20, der an dessen von dem Träger 16 abgewandten Ende radial versteht, gebildet.

Der Drucksensor 12 kann auch zu anderen Zwecken in einem Kraftfahrzeug verwendet werden, zum Beispiel zum Messen des Ansaugunterdrucks des Motors. Der Drucksensor ist dann in eine aus Kunststoff bestehende Grundplatte in dem Ansaugtrakt des Motors eingedrückt Die Auswerteschaltung ist mit der Motorsteuerung verbunden oder in diese integriert. Der Ansaugtrakt, der Motor und die Motorsteuerung sind hier nicht dargestellt, da sie für sich in vielfachen Ausführungen allgemein bekannt sind.

## Patentansprüche

1. Steuergerät (6) in einem Kraftfahrzeug, insbesondere für ein automatisches Getriebe (1), das aufweist:
- mindestens einen Drucksensor (12) zum Messen des Hydraulikdrucks in dem Getriebe,
- ein Gehäuse (8) mit einer metallischen Grundplatte (9), die druckdicht mit einer Hydraulikeinheit (4) des Getriebes (1) verbunden ist, und die mit einer Bohrung (18) versehen ist, durch die der Drucksensor (12) mit dem in der Hydraulikeinheit (4) herrschenden Druck beaufschlagt wird,
- eine elektronische Steuerschaltung (13), die mit dem Drucksensor (12) elektrisch verbunden ist und gemeinsam mit dem Drucksensor (12) in dem Gehäuse (8) untergebracht ist, und
- einen metallischen Träger (16) für den Drucksensor (12), der einen zylinderartigen Vorsprung (20) aufweist,
**dadurch gekennzeichnet, daß** der zylinderartige Vorsprung (20) des metallischen Trägers (16) derart in die Bohrung (18) eingedrückt ist, daß sich durch Verdrängung von unterschiedlich harten metallischen Materialien eine druckdichte und kraftschlüssige Verbindung zwischen dem Träger (16) und der Grundplatte (9) ergibt.

2. Steuergerät nach Anspruch 1, **dadurch gekennzeichnet,**
- **daß** der Träger (16) für den Drucksensor (12) einen zweistufigen zylinderartigen Vorsprung (20) aufweist, dessen erste Stufe (21) einen größeren Durchmesser als die Bohrung (18) der Grundplatte (9) und dessen zweite Stufe (22) einen der Bohrung (18) entsprechenden Durchmesser aufweist, und
- **daß** der Vorsprung (20) derart in die Bohrung (18) der Grundplatte eingedrückt ist, daß ein von seiner ersten Stufe (21) verdrängter Teil des Werkstoffs der Grundplatte (9) hinter einen durch den Übergang zwischen den beiden Stufen (21, 22) des Vorsprungs (20) gebildeten Absatz eingedrungen ist.

3. Steuergerät nach einem der vorhergehenden Ansprüche, **dadurch gekennzeichnet, daß** die Grundplatte (9) gegen die Hydraulikeinheit (4) durch einen O-Ring (19) abgedichtet ist.

4. Steuergerät nach einem der vorhergehenden Ansprüche, **dadurch gekennzeichnet, daß** der Vorsprung (20) an seinen von dem Träger (16) abgewandten Ende einen radial vorstehenden Rand (26) aufweist, der zusammen mit dem ersten Teil des Vorsprungs eine Ringnut (25) bildet.

5. Steuergerät nach einem der vorhergehenden Ansprüche, **dadurch gekennzeichnet, daß** der Träger (16) aus einem harten metallischen Werkstoff und die Grundplatte (9) aus einem weichen Werkstoff besteht.

6. Steuergerät nach einem der vorhergehenden Ansprüche, **dadurch gekennzeichnet, daß** der Träger (16) aus Stahl und die Grundplatte (9) aus Aluminium besteht.

7. Verfahren zum Befestigen eines Drucksensors (12) zum Messen eines Drucks in einem flüssigen oder gasförmigen Medium in einem Kraftfahrzeug auf einer Grundplatte (9), wobei der Drucksensor (12) auf einem metallischen Träger (16) befestigt ist, der einen zylinderartigen Vorsprung (20) aufweist, der in eine Bohrung (18) der Grundplatte (9) eingedrückt wird, **dadurch gekennzeichnet, daß** sich durch Verdrängung von unterschiedlich harten Materialien der Grundplatte und des Trägers eine druckdichte und kraftschlüssige Verbindung zwischen dem Träger (16) und der Grundplatte (9) ergibt.

8. Verfahren nach Anspruch 7, **dadurch gekennzeichnet, daß** der Drucksensor in eine aus Kunststoff bestehende Grundplatte (9) in dem Ansaugtrakt eines Kraftfahrzeugmotors eingedrückt wird und zum Messen des Ansaugunterdrucks dient.

## Claims

1. Control unit (6) in a vehicle, particularly for an automatic transmission (1), that has:
- at least one pressure sensor (12) to measure the hydraulic pressure in the transmission,
- a housing (8) with a metal base plate (9) connected to a hydraulic unit (4) of the transmission (1) forming a pressure-tight seal, and which is provided with a bore (18) through which the pressure existing in the hydraulic unit (4) is felt on the pressure sensor (12),
- an electronic control circuit (13), electrically connected to the pressure sensor (12) and mounted together with the pressure sensor (12) in the housing (8), and
- a metal carrier (16) for the pressure sensor (12), that has a cylinder-type projection (20),
**characterised in that** the cylinder-type projection (20) of the metal carrier (16) is pressed into the bore (18) such that a pressure-proof and positive connection is formed between the carrier (16) and the base plate (9) by the displacement of different hard metal materials.

2. Control unit in accordance with Claim 1, **characterised in that**,
- the carrier (16) for the pressure sensor (12) has a two-step, cylinder-type projection (20), the first step (21) of which has a greater diameter than the bore (18) of the base plate (9) and the second step (22) of which has a diameter corresponding to the bore (18), and
- that the projection (20) is pressed into the bore (18) of the base plate such that a part of the material of the base plate (9) displaced by its first step (21) is forced in by a shoulder formed by the transition between both steps (21,22) of the projection (20).

3. Control unit in accordance with one of the preceding claims, **characterised in that** the base plate (9) is sealed against the hydraulic unit (4) by an o-ring (19).

4. Control unit in accordance with one of the preceding claims, **characterised in that** the projection (20) has a radially projecting rim (26) on its end turned away from the carrier (16), that together with the first part of the projection forms an annular groove (25).

5. Control unit in accordance with one of the preceding claims, **characterised in that** the carrier (16) is made of a hard metal material and the base plate (9) of a soft material.

6. Control unit in accordance with one of the preceding claims, **characterised in that** the carrier (16) is made of steel and the base plate (9) is made of aluminium.

7. Method for attaching a pressure sensor (12) for measuring a pressure in a fluid or gaseous medium in a vehicle on a base plate (9), whereby the pressure sensor (12) is attached to a metal carrier (16) that has a cylinder-type projection (20) that is forced into a bore (18) in the base plate (9), **characterised in that** by the displacement of different hard materials, of the base plate and of the carrier, a pressure-tight and positive connection between the carrier (16) and the base plate (9) is formed.

8. Method in accordance with Claim 7, **characterised in that** the pressure sensor is pressed into a plastic base plate (9) in the intake tract of a vehicle engine and serves to measure the intake vacuum.

## Revendications

1. Appareil de commande (6) dans un véhicule automobile, en particulier pour une boîte de vitesses automatique (1), qui présente:
- au moins un capteur de pression (12) pour mesurer la pression hydraulique dans la boîte de vitesses,
- un carter (8) comportant une plaque de fond métallique (9), qui est reliée, en étant étanche à la pression, à une unité hydraulique (4) de la boîte de vitesses (1), et qui est munie d'un alésage (18), par lequel le capteur de pression (12) reçoit la pression régnant dans l'unité hydraulique (4),
- un circuit de commande électronique (13), qui est relié électriquement au capteur de pression (12) et est installé ensemble avec le capteur de pression (12) dans le carter (8), et
- un support métallique (16) pour le capteur de pression (12), qui présente un prolongement (20) de forme cylindrique,
**caractérisé en ce que** le prolongement de forme cylindrique (20) du support métallique (16) est enfoncé par pression dans l'alésage (18) de façon à obtenir, par refoulement de matériaux métalliques de dureté différente, une liaison à engagement dynamique et étanche à la pression, entre le support (16) et la plaque de base (9).

2. Appareil de commande suivant la revendication 1, **caractérisé en ce que**
- le support (16) destiné au capteur de pression (12) présente un prolongement de forme cylindrique (20) à deux étages, dont le premier étage (21) présente un diamètre plus grand que l'alésage (18) de la plaque de base (9), et dont le deuxième étage (22) présente un diamètre correspondant à l'alésage (18), et
- **en ce que** le prolongement (20) est enfoncé par pression dans l'alésage (18) de la plaque de base (9) de telle façon qu'une partie du matériau de la plaque de base (9), refoulée par son premier étage (21), est refoulée derrière un décrochement formé par la transition entre les deux étages (21, 22) du prolongement (20).

3. Appareil de commande suivant l'une des revendications précédentes, **caractérisé en ce que** la plaque de base (9) est rendue étanche par rapport à l'unité hydraulique (4) au moyen d'un joint torique (19).

4. Appareil de commande suivant l'une des revendications précédentes, **caractérisé en ce que** le prolongement 20) présente, à son extrémité opposée au support (16), une bordure en saillie radiale (26), qui forme, ensemble avec la première partie du prolongement, une rainure annulaire (25).

5. Appareil de commande suivant l'une des revendications précédentes, **caractérisé en ce que** le support (16) est constitué d'un matériau métallique dur et que la plaque de base (9) est constituée d'un matériau tendre.

6. Appareil de commande suivant l'une des revendications précédentes, **caractérisé en ce que** le support(16) est constitué d'acier et la plaque de base (9) est constituée d'aluminium.

7. Procédé pour fixer sur une plaque de base (9) un capteur de pression (12) destiné à mesurer une pression d'un fluide liquide ou gazeux dans un véhicule automobile, le capteur de pression (12) étant fixé sur un support métallique (16) qui présente un prolongement (20) de forme cylindrique qui est enfoncé par pression dans un alésage (18) de la plaque de base (9), **caractérisé en ce que**, par refoulement de matériaux de duretés différentes de la plaque de base et du support, on obtient une liaison par conjugaison de force, étanche à la pression, entre le support (16) et la plaque de base (9).

8. Procédé suivant la revendication 7, **caractérisé en ce que** le capteur de pression (12) est enfoncé par pression dans une plaque de base (9) constituée de matière plastique, dans le trajet d'admission d'un moteur de véhicule automobile, et **en ce qu'**il sert à mesurer la dépression d'aspiration.
